# FASCICULE DE BREVET EUROPEEN

(11) **EP 1 021 833 B1**
(45) Date de publication et mention de la délivrance du brevet: **03.10.2007**
(21) Numéro de dépôt: 98941560.9
(22) Date de dépôt: 06.08.1998
(51) Int. Cl.: H01L 23/58

(54) **DISPOSITIF A CIRCUIT INTEGRE SECURISE ET PROCEDE DE FABRICATION**
GESICHERTE INTEGRIERTE HALBLEITERSCHALTUNGSANORDNUNG UND HERSTELLUNGSVERFAHREN
DEVICE WITH SECURITY INTEGRATED CIRCUIT AND METHOD FOR MAKING SAME

(30) Priorité: 28.08.1997 FR 9710764
(43) Date de publication de la demande: 26.07.2000
(73) Titulaire: Axalto S.A., 92190 Meudon (FR)
(72) Inventeur: BONVALOT, Béatrice, F-91440 Bures-sur-Yvette (FR); LEYDIER, Robert, F-91400 Orsay (FR)
(74) Mandataire: Cassagne, Philippe M.J.
(86) Numéro de dépôt international: PCT/FR1998/001761
(87) Numéro de publication internationale: WO 1999/012204

(56) Documents cités:
- FR-A- 2 727 227
- US-A- 5 155 068
- US-A- 5 476 566

## Description

La présente invention concerne un dispositif à circuit intégré sécurisé comprenant, d'une part, une couche active comportant un matériau semi-conducteur ainsi que des circuits intégrés audit matériau semi-conducteur et présentant, à sa face active, des plots de contact et, d'autre part, une couche complémentaire. Elle concerne en outre un procédé de fabrication d'un tel dispositif.

L'invention s'applique de manière générale au domaine des circuits intégrés et, plus particulièrement, sans pour autant y être limité, au domaine des objets portables à circuit intégré au format carte ou cartes à mémoire.

Telles qu'elles sont réalisées actuellement, les cartes à mémoire se composent le plus souvent d'un corps de carte en matériau plastique dans une cavité duquel est inséré un module électronique. Ce module comprend un circuit intégré ainsi qu'un support dudit circuit intégré. Lorsque la carte est à fonctionnement à contacts, le circuit intégré est connecté à des plages du support du micromodule qui affleurent à la surface du corps de carte et, lorsque la carte est à fonctionnement sans contact, le circuit intégré est connecté aux bornes d'une antenne.

De telles cartes à mémoire sont destinées à la réalisation de diverses opérations telles que, par exemple, des opérations de paiement associées à l'obtention de chaînes télévisées cryptées, des opérations associées au domaine de la santé, des opérations de débit dans des véhicules de transport en commun, des opérations de téléphonie ou des opérations bancaires. Ces opérations s'effectuent en mode lecture ou en mode lecture/écriture grâce à un couplage électrique ou électromagnétique entre le micromodule de la carte et un lecteur.

En vue d'éviter ou, à tout le moins, de limiter les fraudes et/ou les atteintes aux libertés, de nombreux moyens ont été développés. Il s'agit notamment de codes secrets, de clés de cryptage ou d'authentification ou de tables de conversion. Dans les cartes à microcontrôleurs, ces moyens, ainsi que les informations secrètes contenues dans la puce, sont essentiellement contenus dans les mémoires vives électriquement effaçables et programmables (EEPROM) et non volatiles (ROM) de la puce gérées par une unité centrale (CPU).

Il est parfois possible d'accéder aux informations secrètes contenues dans la puce en procédant à une analyse physique des circuits intégrés qu'elle comporte.

C'est la raison pour laquelle différentes techniques ont été développées en vue de sécuriser les circuits intégrés.

Certaines de ces techniques consistent à recouvrir la surface du circuit intégré, notamment la surface des plans mémoire dudit circuit, de couches de polymère et de métal. De par la nature en labyrinthes enchevêtrés de ces couches, il est difficile de reconnaître le routage effectif du circuit.

Le degré de sécurisation obtenu grâce à ces techniques n'est néanmoins pas absolu puisqu'il reste en effet quelquefois possible d'accéder aux circuits et aux informations qu'ils comportent en procédant par des attaques chimiques successives, sélectives des différentes couches.

D'autres techniques proposent de placer un second circuit intégré dit esclave au-dessus d'un circuit intégré maître à protéger et de connecter lesdits circuits intégrés de manière que leur séparation entraîne par exemple une perte irréversible des données sécurisées. Un tel dispositif, décrit dans le brevet français publié sous le numéro 2 727 227, est efficace dans des applications où ledit dispositif est toujours sous tension.

Considérant ce qui précède, un problème technique que se propose de résoudre l'invention est de limiter à moindres coûts et de manière efficace les possibilités d'accès physique au circuit intégré d'un dispositif à circuit intégré sans pour autant nécessiter une alimentation permanente.

Les caractéristiques dans les préambules des revendications 1 et 2 sont connues du document US-A-5 155 068.

Une solution à ce problème, telle que proposée selon l'invention, a pour premier objet un dispositif à circuit intégré sécurisé selon la revendication 2.

Elle a pour second objet un procédé pour la fabrication d'un dispositif à circuit intégré sécurisé selon la revendication 1.

On obtient ainsi un dispositif à circuit intégré sécurisé en rendant critique la récupération de la face active par intrusion physique. De plus, l'épaisseur de l'ensemble couche active/couche complémentaire, c'est-à-dire du dispositif à circuit intégré sécurisé, est de l'ordre de celle d'un dispositif à circuit intégré classique, non sécurisé.

La description qui va suivre, et qui ne comporte aucun caractère limitatif, permettra de mieux comprendre la manière dont l'invention peut être mise en pratique.

Elle est rédigée au regard des dessins annexés, dans lesquels :
- la figure 1 montre, en coupe transversale, un dispositif selon l'invention ;
- la figure 2 montre, en perspective, une tranche à circuits intégrés munie d'une pluralité de dispositifs selon l'invention ;
- les figures 3A à 3F illustrent, en coupe transversale, les différentes étapes de réalisation d'une couche complémentaire d'un dispositif à circuit intégré sécurisé selon l'invention ;
- les figures 4A à 4C illustrent, en coupe transversale, les différentes étapes de préparation d'une couche active d'un dispositif à circuit intégré sécurisé selon l'invention ; et
- les figures 5A à 5D illustrent, en coupe transversale, les différentes étapes d'obtention du dispositif à circuit intégré sécurisé selon l'invention, à partir des couches réalisées selon les étapes illustrées aux figures 3A à 3F et 4A à 4C.

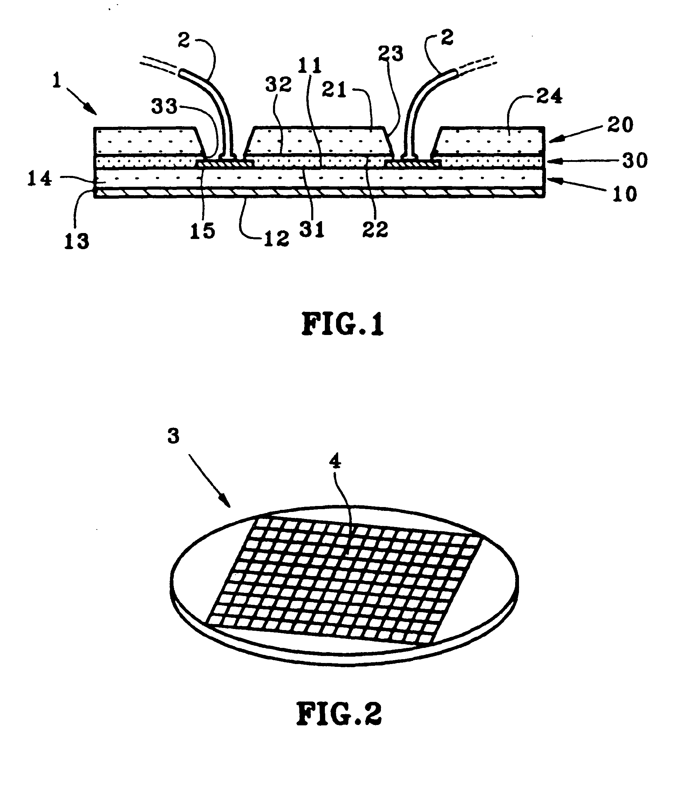

Ainsi que cela est montré à la figure 1, un dispositif 1 à circuit intégré sécurisé selon l'invention comporte deux couches principales, une couche active 10 amincie et une couche complémentaire 20, lesdites couches 10, 20 étant scellées l'une à l'autre par une couche intermédiaire 30.

La couche active 10 amincie comporte une face active 11 et une face 12 opposée à sa face active 11. La couche complémentaire 20 comporte une face de dessus 21 et une face de dessous 22.

Les couches 10 et 20 sont solidaires l'une de l'autre, scellées l'une à l'autre par la couche 30. Dans la convention utilisée dans les dessins, la couche active 10 amincie est placée au-dessous de la couche complémentaire 20, la face active 11 de la couche active 10 et la face de dessous 22 de la couche complémentaire 20 venant au contact des faces de dessous 31 et de dessus 32 de la couche 30, respectivement.

L'épaisseur de l'ensemble des couches 10, 20 et 30 superposées est avantageusement de l'ordre de celle d'un dispositif à circuit intégré classique non sécurisé tel que commercialisé en tranches par les fondeurs, soit de l'ordre de 150 µm. Cet ensemble peut donc être intégré sans difficulté dans un module destiné à la fabrication de cartes à mémoire. Il peut être même intégré tel quel dans des corps de carte, selon des procédés connus du type MOSAÏC (marque déposée).

La couche active 10 amincie a une épaisseur comprise entre 5 et 50 µm, par exemple de l'ordre de 10 µm, soit une épaisseur bien inférieure à celle de la couche active d'un dispositif classique du type précité, portant les circuits intégrés. Elle se compose de différentes sous-couches superposées, éventuellement une sous-couche 13 et une sous-couche active 14.

La sous-couche 13, dont l'épaisseur est comprise entre 0,1 et 3 µm, par exemple de l'ordre de 0,4 µm, est constituée d'un matériau isolant, notamment de dioxyde de silicium (SiO₂) dont l'une des fonctions est de limiter les courants de fuites au niveau des puits constitutifs des circuits. Cette sous-couche 13 peut cependant être constituée d'un autre matériau. Par exemple, elle peut être constituée par une épaisseur du substrat Silicium qui sera polarisée à un potentiel différent de celui de la sous-couche active 14 lors de l'amincissement. En définitive, la sous-couche 13 se démarque de la sous-couche active 14 au moins par une caractéristique physico-chimique.

La sous-couche active 14, placée immédiatement au-dessus de la sous-couche 13, a une épaisseur comprise entre 5 et 50 µm, par exemple de l'ordre de 10 µm. C'est une sous-couche épitaxiée sur laquelle sont intégrés les circuits électroniques. Cette sous-couche 14 comporte donc classiquement plusieurs épaisseurs imbriquées et sa surface se partage en différentes zones, en particulier des zones mémoire ROM et EEPROM qui mémorisent des informations sécrètes que l'on souhaite protéger.

Des plots de contact métalliques 15 d'entrée/sortie affleurent à la surface de la sous-couche active 14 ou sont excroissants de celle-ci.

La couche 30 de scellement est constituée d'un matériau isolant montrant une grande inertie au point de vue chimique et en particulier une forte insensibilité aux solvants classiques. Il s'agit notamment d'une couche d'un polyimide. Cette couche 30 montre des ouvertures 33 à l'aplomb des plots 15.

La couche complémentaire 20 a une épaisseur comprise entre 80 et 600 µm selon que celle-ci a été amincie ou non. Elle est constituée d'un matériau solide, rigide, opaque, avantageusement un matériau semi-conducteur qui a la propriété de pouvoir être gravé ou usiné. Ce matériau semi-conducteur est préférentiellement le même que le matériau semi-conducteur constitutif de la sous-couche active 14 de la couche active 10, c'est-à-dire du Silicium notamment du Silicium minocristalin. De ce fait, il n'est pas possible de distinguer les couches 10 et 20 par leur réactivité physico-chimique. On notera que, compte tenu du fait que la couche active 10 amincie a une faible épaisseur, il devient critique que les matériaux constitutifs de la couche complémentaire 20 présentent des caractéristiques physiques identiques ou très voisines des caractéristiques physiques de la couche active amincie 10. Dans le cas contraire, différentes réactions physiques des couches 10 et 30 pourraient perturber l'intégrité physique du dispositif de l'invention. Par exemple, une différence de coefficient de dilatation thermique entre les couches 10 et 30 pourraient être à l'origine de microfissures de la couche 10 amincie rendant celle-ci particulièrement fragile sous l'effet d'une élévation de la température.

Par ailleurs, la couche 20 est percée de vias 23 ou de tout autres moyens destinés à permettre une connexion électrique avec les plots 15 notamment des trous métallisés. Dans le cas de vias simples, la connexion électrique est effectivement réalisée, dans le dispositif 1, par des fils 2 conducteurs métalliques, par exemple des fils d'or ou d'aluminium.

Ainsi, dans le cas où un fraudeur viendrait à vouloir accéder aux circuits intégrés d'un dispositif sécurisé selon l'invention pour en déterminer l'architecture et pour en extraire les informations secrètes que ledit dispositif est susceptible de comporter, ledit fraudeur serait amené, par exemple, à tenter de séparer la couche complémentaire 20 de la couche active 10.

A cet effet, ce fraudeur pourrait appliquer, sur l'ensemble des couches 10, 20, des forces de tractions. Dans ce cas, la couche 10 amincie, considérablement fragilisée, se briserait en de multiples endroits ce qui rendrait la détermination de l'architecture des circuits et l'extraction des informations secrètes impossible.

Le fraudeur pourrait par ailleurs tenter de dégrader la couche complémentaire 20 puis la couche de scellement 30. Etant donné que cet agent de scellement est avantageusement résistant aux solvants classiques, ledit fraudeur serait conduit à utiliser, pour dégrader lesdites couches 20 et 30, des bases ou des acides forts. Or, de telles bases détruisent le Silicium, non seulement celui de la couche complémentaire 20, mais aussi, celui de la couche active 10. Les acides forts détruisent quant à eux les métaux constitutifs des pistes formant les circuits intégrés. La détermination de l'architecture des circuits intégrés et l'extraction des informations serait donc, là aussi, interdite.

Il en irait de même pour des méthodes d'intrusion optiques. A ce sujet, on notera que la couche complémentaire 20 constitue une barrière efficace aux rayons ultra-violets (UV) ou infra-rouges (IR) et empêche de ce fait une éventuelle perturbation des circuits due à la lumière UV ou IR.

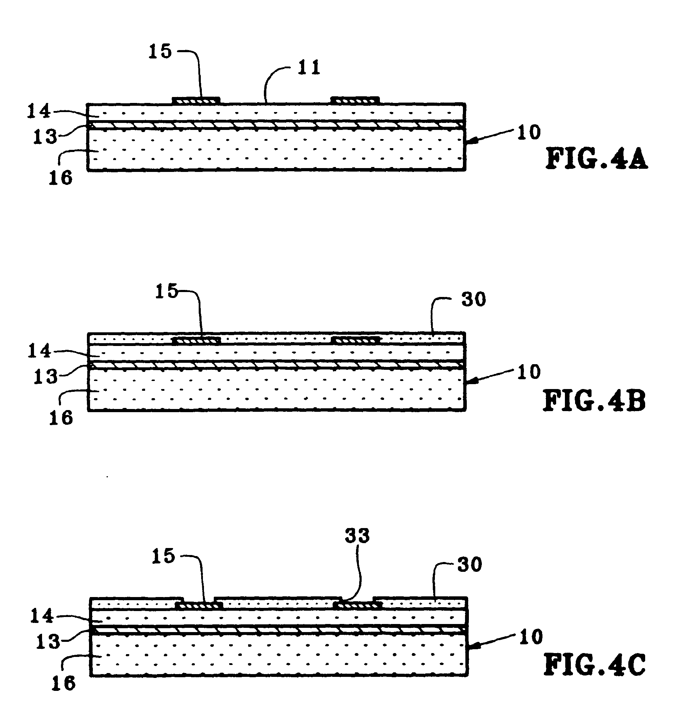

Pour la fabrication d'un dispositif 1 selon l'invention, on réalise la couche complémentaire 20, on applique, sur une couche active 10 non amincie du type montrée en figure 4C, l'agent de scellement, on scelle la couche 20 à la couche 10 revêtue de l'agent de scellement et, dans une étape ultérieure, on amincit la couche 10 scellée.

Pour des raisons de simplicité, les étapes de fabrication d'un dispositif sécurisé selon l'invention sont principalement décrites au regard d'un unique dispositif 1, c'est-à-dire d'une puce. En pratique, ces étapes sont toutefois avantageusement mises en oeuvre par lots sur des tranches de Silicium. Il s'agit, en ce qui concerne la préparation de la couche active 10, de tranches de Silicium 3 ("wafer" selon la terminologie anglo-saxonne) comportant une pluralité de dispositifs à circuit intégré 4 placés côte-à-côte (figure 2) et, en ce qui concerne la réalisation des couches complémentaires 20, de tranches de Silicium sensiblement au même format mais ne comportant pas de circuits intégrés. En procédant par tranches, on obtient en effet rapidement un grand nombre de dispositifs à circuits intégrés sécurisés. Aussi, cette mise en oeuvre qui, on le notera, n'exige pas de modification préalable de la part des fondeurs, constitue un avantage certain de l'invention.

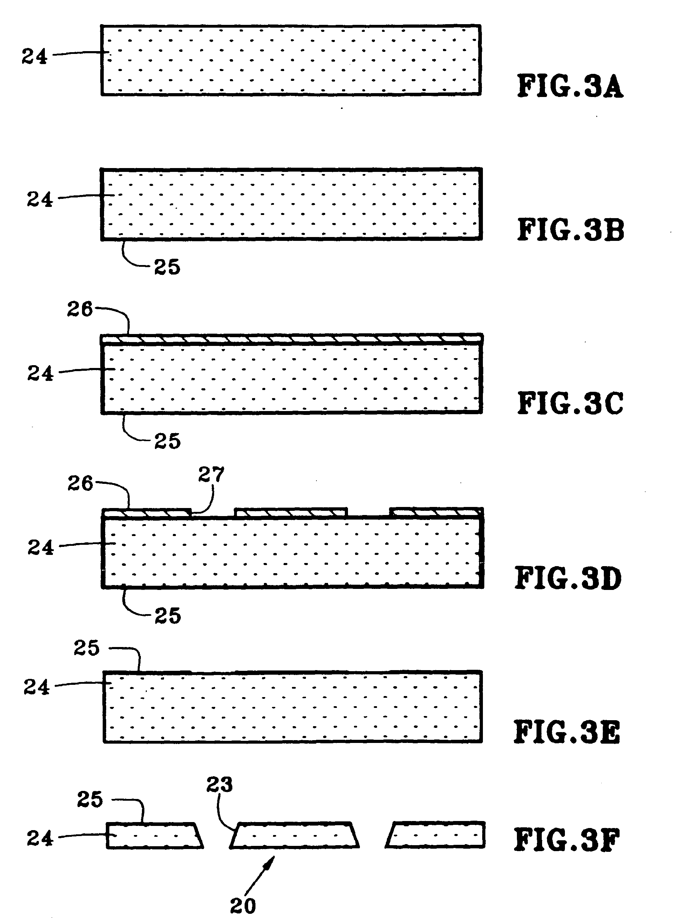

Pour la réalisation de la couche complémentaire 20, on procède selon les étapes illustrées aux figures 3A à 3F.

Dans une première étape, un substrat 24 semi-conducteur, notamment une plaquette de Silicium d'une épaisseur de l'ordre de 400 µm (figure 3A), est soumise à une oxydation et, éventuellement, à une nitruration. Cette plaquette 24 montre alors, à sa périphérie, une couche d'oxyde 25 et, éventuellement, une couche de nitrure (figure 3B).

On dépose ensuite, sur l'une des faces oxydées de la plaquette 24, une couche photosensible 26 (figure 3C).

Cette couche photosensible 26 est alors insolée au travers d'un masque, les éléments de surface insolés de ladite couche 26 laissant place à des ouvertures 27 (figure 3D).

Il est alors possible de dégrader sélectivement la couche d'oxyde 25 aux endroits qui ne sont pas protégés par la couche photosensible 26, c'est-à-dire, notamment, à l'endroit des ouvertures 27 et, éventuellement, sur la face de la plaquette 24 opposée à la face portant lesdites ouvertures 27 (figure 3E).

En vue d'obtenir la couche 20 (figure 3F), la plaquette 24 de la figure 3E est ensuite usinée. Cet usinage se fait par des techniques de gravure sèche ou humide. Il permet de réaliser, aux endroits des ouvertures 27 précitées, les vias 23. Il permet par ailleurs de procéder simultanément à un amincissement de ladite plaquette 24 jusqu'à une épaisseur de l'ordre de 100 µm voire 80 µm.

Parallèlement aux étapes décrites ci-dessus, on applique l'agent de scellement sur une couche active 10 non amincie.

Cette couche active 10 non amincie présente, telle que montrée à la figure 4A, une sous-couche 16 de silicium. En fait, eu égard à la présence, au sein de la couche 10 non amincie, de la sous-couche de SiO₂, l'ensemble des couches 16, 13, 14 forme un substrat du type SOI (« Silicium On Insulator » selon la terminologie anglo-saxonne) où les circuits sont implantés dans une zone isolée de la masse de Si par la couche d'oxyde.

L'agent de scellement polymérique est appliqué, à la surface de la face active 11 de la couche active 10 non amincie, sous une forme visqueuse. Il forme alors la couche 30 qui recouvre les plots 15 (figure 4B).

Dans le cas avantageux où l'agent de scellement est photosensible, il est directement insolé au travers d'un masque. Les ouvertures 33 sont ainsi ménagées et dégagent, au moins partiellement, la surface des plots 15 (figure 4C). Dans le cas contraire, il est alors nécessaire d'appliquer, à la surface de la couche de scellement 30, une couche photosensible et d'ouvrir ladite couche photosensible à la manière décrite en référence aux figures 3C à 3E.

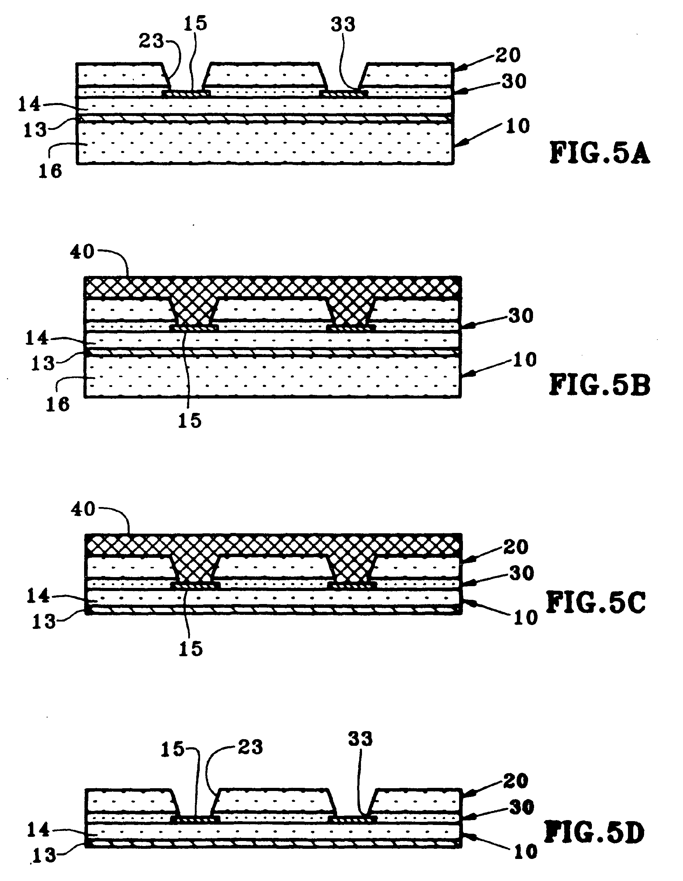

Enfin, on procède, selon l'invention, aux étapes qui vont conduire à la sécurisation du dispositif selon l'invention. Ces étapes sont illustrées aux figures 5A à 5E.

On place tout d'abord la couche complémentaire 20 de la figure 3F à la surface de l'ensemble des couches 10, 30 de la figure 4C de manière que les vias 23 soient positionnées à la verticale des plots 15.

Puis, on scelle la couche 20 à la couche 10 non amincie par thermo-compression. En pratique, on applique à cet effet auxdites couches 10 et 20 superposées, d'une part, une température de l'ordre de 300 °C et inférieure à la température de 400 °C environ qui correspond en définitive à la température limite que peuvent supporter les pistes d'aluminium formant les circuits intégrés et, d'autre part, une pression de l'ordre de 10 bars.

Puis, en vue d'amincir la couche 10, on protège avantageusement l'ensemble 10, 20, 30 scellé par un bloc de protection mécanique 40 que l'on applique à la face supérieure dudit ensemble, à la surface de la couche 20 et au creux des vias 23 (figure 5B). Il est alors tout à fait possible d'usiner la face arrière de la couche 10 de manière à amincir l'ensemble scellé jusqu'à une épaisseur de l'ordre de 150 µm, soit une épaisseur sensiblement égale à l'épaisseur d'un dispositif classique non sécurisé de l'état de la technique. Bien entendu, l'amincissement est calculé de manière que la sous-couche active ne subisse pas d'usinage. La présence de la couche 13 permet d'ailleurs de garantir un arrêt de l'usinage et un contrôle précis de l'épaisseur de la zone active, indépendamment des caractéristiques du parallélisme des deux faces de la tranche à circuits intégrés.

Une fois que l'on a procédé à l'usinage, il est alors possible de retirer la protection 40 (figure 5D).

Les fils 2 sont ensuite connectés aux plots 15 selon l'une des méthodes classiques connues ("wire bonding" ou "wedge bonding" notamment selon la terminologie anglo-saxonne).

Bien entendu, dans le cas où le procédé de l'invention est mis en oeuvre sur une tranche à circuits intégrés, les étapes de bonding sont précédées d'une découpe des dispositifs sécurisés de la tranche et, par exemple, d'un report desdits dispositifs sur une bande métallisée ("lead frame" selon la terminologie anglo-saxonne) et suivie d'un enrobage de résine avant que le module soit reporté dans un corps de carte.

## Revendications

1. Procédé pour la fabrication d'un dispositif à circuit intégré sécurisé comprenant, d'une part, une couche active (10) comportant un matériau semi-conducteur ainsi que des circuits intégrés audit matériau semi-conducteur et présentant, à sa face active (11), des plots (15) de contact et, d'autre part, une couche complémentaire (20) scellée à la couche active (10) par une couche intermédiaire (30) appliquée à la surface de la face active (11) de la couche active (10), dans lequel procédé la couche active (10) est amincie par sa face (12) opposée à sa face active (11) jusqu'à ce que la couche active ait une épaisseur comprise entre 5 et 50 µm, **caractérisé en ce que** la couche complémentaire (20) a une épaisseur comprise entre 80 et 600 µm.

2. Dispositif à circuit intégré sécurisé comprenant, d'une part, une couche active (10) ayant une épaisseur comprise entre 5 et 50 µm, et comportant un matériau semi-conducteur ainsi que des circuits intégrés audit matériau semi-conducteur et présentant, à sa face active (11), des plots (15) de contact et, d'autre part, une couche complémentaire (20) scellée à la couche active (10) par une couche intermédiaire (30) appliquée à la surface de la face active (11) de la couche active (10), **caractérisé en ce que** la couche complémentaire (20) a une épaisseur comprise entre 80 et 600 µm.

3. Dispositif selon la revendication 2, **caractérisé en ce que** la couche complémentaire (20) comporte un matériau semi-conducteur.

4. Dispositif selon la revendication 3, **caractérisé en ce que** le matériau semi-conducteur de la couche complémentaire (20) est du Silicium.

5. Dispositif selon l'une des revendications 2 à 4, **caractérisé en ce que** la couche complémentaire (20) est percée de vias (23) ou de tous autres moyens destinés à permettre une connexion électrique avec les plots (15).

6. Dispositif selon l'une des revendications 2 à 5, **caractérisé en ce que** la couche active (10) présente, à sa face (12) opposée à sa face active (11), une sous-couche (13) qui se démarque de la sous-couche active (14) par au moins une caractéristique physico-chimique.

7. Dispositif selon la revendication 6, **caractérisé en ce que** la sous-couche (13) est une sous-couche de dioxyde de Silicium.

8. Tranche de matériau semi-conducteur, **caractérisée en ce qu'**elle est munie d'une pluralité de dispositifs selon l'une des revendications 2 à 7.

9. Objet portable à circuit intégré au format carte ou cartes à mémoire comprenant un dispositif selon l'une des revendications 2 à 7.

## Claims

1. A method of manufacturing a secure integrated circuit device comprising firstly an active layer (10) made up of a semiconductor material and of circuits integrated into said semiconductor material and having contact tabs (15) on its active face (11), and secondly an additional layer (20), bonded to the active layer (10) by an intermediate layer (30) applied to the surface of the active face (11) of the active layer (10), and the face (12) of the active layer (10) opposite from its active face (11) is thinned until the active layer has a thickness lying in the range 5 µm to 50 µm, said method being **characterized in that** the additional layer (20) has a thickness lying in the range 80 to 600 *µ*m.

2. A secure integrated circuit device comprising firstly an active layer (10) having a thickness lying in the range 5 to 50 µm, and made up of a semiconductor material and of circuits integrated into said semiconductor material and having contact tabs (15) on its active face (11), and secondly an additional layer (20), bonded to the additional layer (20) by an intermediate layer (30) applied to the surface of the active face (11) of the active layer (10), said device being **characterized in that** the additional layer (20) has a thickness lying in the range of 80 to 600 µm.

3. A device according to claim 2, **characterized in that** the additional layer (20) comprises a semiconductor material.

4. A device according to claim 3, **characterized in that** the semiconductor material of the additional layer (20) is silicon.

5. A device according to one of claims 2 to 4, **characterized in that** the additional layer (20) is provided with vias (23) or with any other means serving to enable electrical connection to be established with the tabs (15).

6. A device according to anyone of claims 2 to 5, **characterized in that**, on that face (12) of the active layer (10) which is opposite from its active face (11), said active layer has a sub-layer (13) which differs from the active sub-layer (14) by at least one physicochemical characteristic.

7. A device according to claim 6, **characterized in that** the sub-layer (13) is a sub-layer of silicon dioxide.

8. A wafer of semiconductor material, **characterized in that** it is provided with a plurality of devices according to anyone of claims 2 to 7.

9. Portable object having integrated circuits of the format of a memory card or card, comprising a device according to anyone of claims 2 to 7.

## Patentansprüche

1. Verfahren zur Herstellung einer Vorrichtung mit integrierter, geschützter Schaltung mit einerseits einer aktiven Schicht (10), die ein Halbleitermaterial sowie in das besagte Halbleitermaterial integrierte Schaltungen umfasst sowie Kontaktstifte (15) auf ihrer aktiven Seite (11), und andererseits einer Zusatzschicht (20), die mit der aktiven Schicht (10) versiegelt ist über eine Zwischenschicht (30), die auf die Oberfläche der aktiven Seite (11) der aktiven Schicht (10) aufgetragen ist, bei welchem Verfahren die aktive Schicht (10) auf ihrer der aktiven Seite (11) gegenüberliegenden Seite (12) verdünnt ist, bis die aktive Schicht eine Stärke zwischen 5 und 50 µm besitzt, **dadurch gekennzeichnet, dass** die Zusatzschicht (20) eine Stärke zwischen 80 und 600 µm besitzt.

2. Vorrichtung mit integrierter geschützter Schaltung mit einerseits einer aktiven Schicht (10), die eine Stärke zwischen 5 und 50 µm besitzt und ein Halbleitermaterial umfasst sowie in das besagte Halbleitermaterial integrierte Schaltungen sowie Kontaktstifte (15) auf ihrer aktiven Seite (11), und andererseits einer Zusatzschicht (20), die mit der aktiven Schicht (10) versiegelt ist über eine Zwischenschicht (30), die auf die Oberfläche der aktiven Seite (11) der aktiven Schicht (10) aufgetragen ist, **dadurch gekennzeichnet, dass** die Zusatzschicht (20) eine Stärke zwischen 80 und 600 µm besitzt.

3. Vorrichtung nach Anspruch 2, **dadurch gekennzeichnet, dass** die Zusatzschicht (20) ein Halbleitermaterial umfasst.

4. Vorrichtung nach Anspruch 3, **dadurch gekennzeichnet, dass** das Halbleitermaterial der Zusatzschicht (20) Silizium ist.

5. Vorrichtung nach einem der Ansprüche 2 bis 4, **dadurch gekennzeichnet, dass** in die Zusatzschicht (20) Lücken (23) oder andere Mittel gebohrt sind, mit denen eine elektrische Verbindung mit den Kontakten (15) möglich ist.

6. Vorrichtung nach einem der Ansprüche 2 bis 5, **dadurch gekennzeichnet, dass** die aktive Schicht (10) auf ihrer der aktiven Seite (11) gegenüberliegenden Seite (12) eine Unterschicht (13) aufweist, die sich von der aktiven Unterschicht (14) durch mindestens ein physikalisch-chemisches Merkmal unterscheidet.

7. Vorrichtung nach Anspruch 6, **dadurch gekennzeichnet, dass** die Unterschicht (13) eine Unterschicht aus Siliziumdioxid ist.

8. Scheibe aus Halbleitermaterial, **dadurch gekennzeichnet dass** sie mehrere Vorrichtungen nach einem der Ansprüche 2 bis 7 umfasst.

9. Tragbarer Gegenstand mit integrierter Schaltung im Kartenformat oder Speicherkartenformat mit einer Vorrichtung nach einem der Ansprüche 2 bis.
